# EUROPEAN PATENT SPECIFICATION

(11) **EP 1 498 244 B1**
(45) Date of publication and mention of the grant of the patent: **04.10.2006**
(21) Application number: 04016747.0
(22) Date of filing: 15.07.2004
(51) Int. Cl.: B29B 9/08, B29B 9/10, H01L 23/29, B29C 45/46

(54) **Method for producing a semiconductor-molding tablet**
Verfahren zur Herstellung eines Harzverkapselungsscheibchens für Halbleiter
Procédé pour produire une tablette de résine de scellement pour semi-conducteurs

(30) Priority: 17.07.2003 JP 2003198550
(43) Date of publication of application: 19.01.2005
(73) Proprietor: NITTO DENKO CORPORATION, Osaka (JP)
(72) Inventor: Oono, Hirofumi, Ibarakai-shi Osaka (JP); Yamane, Minoru, Ibarakai-shi Osaka (JP); Ina, Yasunobu, Ibarakai-shi Osaka (JP); Umeno, Shouichi, Mitagawa-cho Kanzaki-gun Saga 842-0031 (JP)
(74) Representative: Grünecker, Kinkeldey, Stockmair & Schwanhäusser Anwaltssozietät

(56) References cited:
- DE-A- 4 414 939
- GB-A- 1 065 672
- US-A- 5 645 787
- US-B1- 6 207 296
- PATENT ABSTRACTS OF JAPAN vol. 1996, no. 06, 28 June 1996 (1996-06-28) -& JP 08 039549 A (SUMITOMO BAKELITE CO LTD), 13 February 1996 (1996-02-13)
- DATABASE WPI Section Ch, Week 198606 Derwent Publications Ltd., London, GB; Class A21, AN 1986-038271 XP002304916 -& JP 60 257548 A (HITACHI CHEM CO LTD) 19 December 1985 (1985-12-19)
- DATABASE WPI Section Ch, Week 198408 Derwent Publications Ltd., London, GB; Class A31, AN 1984-046150 XP002304917 -& JP 59 007009 A (TOKYO SHIBAURA DENKI KK) 14 January 1984 (1984-01-14)

## Description

The present invention relates to a method for producing a semiconductor-molding tablet which is used in the molding material for a semiconductor device and can prevent formation of internal voids in the molding resin part, a semiconductor-molding tablet obtained thereby and a semiconductor device having high reliability, which is obtainable using the same.

A tablet for a semiconductor is known from JP 08039549. Therein, different particle sizes are combined to a tablet.

From JP 60257548 a manufacturing method of moving material for sealing is known. Therein, the temperature is the essential parameter.

JP 597009 reveals a high density resin palette seal semiconductor assemble forming a tablet powder material under high pressure vacuum.

In the German document DE 4414939 A1 a method to compact molden mixture of an epoxy resin powder is revealed.

GB 1065672 reveals a densifier for powdery substances.

US 6207296 B1 reveals an inorganic filler, an epoxy resin composition and a semiconductor device.

US 5645787 reveals a process for producing semiconductor devices using resin tablets.

Conventionally, a powdery material prepared by blending and melt-kneading an epoxy resin, a phenol resin and an inorganic filler or the like and then rolling, cooling and pulverizing the resulting material is used as a molding material for semiconductor elemental devices such as IC, LSI and the like. The semiconductor device may be molded with the resin by directly feeding the powdery material obtained in this manner into a molding machine for package molding use, but it is more general to employ a method in which the semiconductor device is molded with the resin by making a tablet in advance by compressing the material in an amount necessary for the molding in a mold of a desired shape, and subsequently feeding this into a molding machine for package molding.

The tablet prepared in advance by compression molding is used as a molding material in this manner, because voids among pulverized particles of the molding material are compressed to become smaller in the compression-molded tablet and the amount of so-called "air" contained in the tablet is thus reduced. Accordingly, by the use of such a tablet as the molding material, voids hardly remain inside and on the surface of the package after molding, and reliability after molding and yield of the molding step are markedly improved.

However, because thinning of a semiconductor device is in progress recently, thickness of the molding resin layer also becomes thin in such a thin package as a matter of course. Thus, even the voids which did not cause a problem in the prior art become a serious reason for problems in the thin type package. Accordingly, there is a demand for the increased tablet density for the purpose of reducing the void formation ratio. For example, for the purpose of increasing tablet density, it has been proposed to obtain a high density tablet by regulating the filling structure of particles by restricting particle size distribution of the pulverized material before tablet making (cf. Reference 1). Alternatively, a method for producing an epoxy resin molding material has been proposed, in which temperature of the material discharged from a kneader is specified, and characteristics of the molding material obtained by cooling and pulverizing this discharged material are restricted (cf. Reference 2). Reference 1:
JP-A-8-39549
Reference 2:
JP-A-2002-220475

The term "JP-A" as used herein means an "unexamined published Japanese patent application".

However, the above-described effects are hardly obtained in the recent high density region of tablets, so that the actual situation is that it was necessary to depend on the high pressurization of pressing force at the time of the tablet making after all. As a result, the tablet density ratio has already reached the level of 94% by true specific gravity ratio, and further higher pressurization causes generation of distortion and breakage of the molding apparatus and is also generating problems such as reduction of the yield at the time of the tablet production, so that it is the present situation that solving of the problems by the tablet producing apparatus itself has limitation.

The present invention was accomplished with taking such situations into consideration. The present invention provides a method for producing a semiconductor-molding tablet which can reduce generation of voids inside of the package through increased density of the tablet, a semiconductor-molding tablet obtained thereby and a semiconductor device having high reliability, which is obtainable by using the same.

In order to achieve the aforementioned objects, the first embodiment of the present invention is a method according to claim 1.

That is, the present inventors have conducted a series of studies with the aim of obtaining a tablet having a high density which had limitation by the conventional tablet-making molding apparatus. As a result, it was found that it is impossible to make a tablet having further high density by compressing the cooled and hardened pulverized particles and thereby removing the air in the powder, by employing only the conventional pressurization at the time of making a pulverized material as a resin composition for semiconductor molding into a tablet. As a result of further contained studies based on this finding, the inventors found the following for the first time. With respect to a molding material before making the table, a method in which a kneaded and discharged material in which the formulation components of the aforementioned molding material are under a molten state is made into a sheet shape having a high density ratio by rolling, and this rolled sheet is pulverized and made into a tablet shape can achieve the results that the air in the powder as the pulverized material is sharply removed and, what is more, a tablet having still more higher density can be obtained while carrying out reduction of pressure force at the time of the tablet-making, and that the use of this renders possible production of a semiconductor-molding tablet capable of inhibiting formation of voids in the package when a semiconductor elemental device is molded using the same. Thus, the present invention was accomplished.

Next, embodiments of the present invention are described in detail.

The semiconductor-molding tablet produced according to claim 1 is obtained by using an epoxy resin composition containing an epoxy resin (component A), a phenol resin (component B) and an inorganic filler (component C) as the essential components, kneading and molding this into a sheet shape having a specified thickness, pulverizing the product, and then making the pulverized material into a tablet shape by a tablet-making molding.

The aforementioned epoxy resin (component A) is not particularly limited and conventionally known various epoxy resins may be used. Examples thereof include various types 20 of epoxy resins such as cresol novolak type, phenol novolak type, bisphenol A type, biphenyl type, triphenylmethane type, naphthalene type and the like. These can be used alone, or two or more of them may be used in combination.

The phenol resin (component B) to be used together with the aforementioned epoxy resin (component A) exerts an effect as the hardening agent for the aforementioned epoxy resin. It is not particularly limited, and its examples include conventionally known materials such as phenol novolak, cresol novolak, bisphenol A type novolak, naphthol novolak, a phenol aralkyl resin and the like. These may be used alone or as a combination of two or more.

It is desirable to mix the aforementioned epoxy resin (component A) and phenol resin (component B) at such a mixing ratio that the hydroxyl group equivalent in the hardening agent becomes from 0.5 to 2.0 equivalents based on 1 equivalent of epoxy group in the epoxy resin. More preferred is from 0.8 to 1.2 equivalents.

The inorganic filler (component C) to be used together with the aforementioned epoxy resin (component A) and phenol resin (component B) is not particularly limited, and conventionally known various fillers can be exemplified, such as quartz glass powder, talc, silica powders (fused silica powder, crystalline silica powder and the like), alumina powder, aluminum nitride powder, silicon nitride powder and the like. These may be used alone or as a combination of two or more. Among them, it is desirable to use the aforementioned silica powders from the viewpoint that linear expansion coefficient of the obtained hardened product can be reduced. Among the aforementioned silica powders, it is particularly desirable to use fused silica powder in terms of high packing and high fluidity. As the aforementioned fused silica powder, spherical fused silica powder and pulverized fused silica powder can be exemplified, and it is desirable to use the spherical fused silica powder in view of fluidity. Particularly, it is desirable to use the one having an average particle size of within the range of from 10 to 60 µm, particularly preferably within the range of from 15 to 45 µm. In this connection, the aforementioned average particle size can be measured using, for example, a laser diffraction scattering type particle size distribution measuring apparatus.

It is desirable to set the content of the aforementioned inorganic filler (component C) to a range of from 50 to 95% by weight, particularly preferably from 70 to 90% by weight, based on the whole epoxy resin composition.

According to the present invention, in addition to the aforementioned components A to C, other additives including a hardening accelerator, a halogen-based flame retardant such as a brominated epoxy resin or the like, a flame retard assisting agent such as antimony trioxide or the like, a pigment such as carbon black or the like, a silane coupling agent such as β-(3,4-epoxycyclohexyl)ethyl trimethoxysilane, γ-glycidoxypropyl trimethoxysilane or the like, and a release agent such as carnauba wax or the like are optionally used as occasional demands.

The aforementioned hardening accelerator is not particularly limited. Examples thereof include imidazoles such as 2-methylimidazole and the like, triethanolamine, organic phosphorus compounds such as tetraphenylphosphonium, tetraphenyl borate, triphenylphosphine and the like, and diazabicycloalkene compounds such as 1,8-diazabicyclo[5.4.0]undecene-7, 1,5-diazabicyclo[4.3.0]nonene-5, and the like. These compounds may be used alone or as a combination of two or more. In addition, it is preferable to set the blending ratio of this hardening accelerator to a ratio of from 0.1 to 1.0% by weight based on the whole epoxy resin composition.

The semiconductor-molding tablet obtained by the method of the present invention is produced using the aforementioned respective components, for example in the following manner. That is, the aforementioned respective components are mixed at a predetermined ratio, dry-blended using a mixer or the like and then kneaded using a twin screw kneader at a resin temperature of from 90 to 130°C. Next, the kneaded material discharged from the aforementioned kneader is rolling-molded into a sheet shape in such a manner that the sheet density ratio becomes 98% or more, and then the aforementioned sheet is air-cooled and pulverized. Subsequently, the semiconductor-molding tablet of interest is produced by molding the thus obtained pulverized material into a tablet shape using a tablet-making machine by compressing to a predetermined tablet height in such a manner that the desired tablet density ratio can be obtained.

As described in the foregoing, the aforementioned rolling-molded sheet is molded into a sheet density ratio of 98% or more. In that case, it is preferable to make the sheet by rolling it to a thickness of 1.0 mm or less. In describing in detail, the conventional sheets by roll molding generally have a thickness of 2 mm or more, and the sheet density ratio in that case is approximately from 93 to 97%. According to the present invention, it becomes possible to achieve a sheet density ratio of from 98 to 99% in the case of a sheet thickness of 1.0 mm, or a sheet density ratio of from 99 to 100% in the case of a sheet thickness of from 0.7 to 0.5 mm. Accordingly, it is particularly preferable to set the sheet thickness to 0.7 mm or less in relation to the sheet density ratio. The lower limit of the sheet is generally 0.2 mm. Thus, it becomes possible to achieve a high density molding to a sheet density ratio of 98% or more by rolling to a sheet thickness of 1.0 mm or less, because the voids scattered inside of the kneaded material discharged from the kneader and the voids formed by the air bubbles engulfed during transfer to the roller can be efficiently removed by rolling to a sheet shape under a molten state.

In this connection, regarding the method for setting the sheet density ratio to 98% or more as described in the above, a method by increasing the kneading performance, discharging at a high temperature or the like can be exemplified, in addition to the method for setting sheet thickness to 1.0 mm or less. Illustrative examples thereof include decompression or degassing treatment in the kneader, prolongation of the kneading time, increase of the kneading temperature and the like methods.

In this regard, the aforementioned sheet density ratio is measured and calculated in the following manner. That is, specific gravity of a sheet is measured by a specific gravity measuring method (based on JIS K 6911) in which it is calculated from the mass of the obtained sheet in air and its mass in water, and the sheet density ratio is calculated by its ratio with true specific gravity value of the molding material compact (hardened product of the resin composition) obtained in the same manner. In more illustratively describing, specific gravity of the sheet is obtained by the aforementioned specific gravity measuring method. On the other hand, a hardened product of the aforementioned resin composition is molded under molding conditions of: temperature 175°C x 2 minutes, 6.865 MPa, after hardening 175°C x 5 hours, and true specific gravity of the molding material compact is calculated by the specific gravity measuring method in the same manner as described in the above. Thereafter, the sheet density ratio is calculated from these measured values based on the following formula, sheet density ratio (%) = [(specific gravity of sheet)/(true specific gravity of molding material compact)] x 100.

For the pulverization of the sheet, usual pulverizers having a hardness higher than that of the filler may be used and examples of the pulverizers include a hammer mill.

The particle size of the pulverized resin composition may be confirmed by checking the particle size distribution using a JIS standard sieve.

According to the present invention, the pulverized material preferably has 50% by weight or less of the pulverized particles that remain on the 1.0 mm sieve without passing the sieve, based on the total weight of the pulverized material. If the amount is higher than 50% by weight, there may be a tendency that, even if the sheet density ratio is controlled to be high, voids may remain among the particles and voids during molding tend to increase.

Also, the pulverized material preferably has from 10 to 40% by weight, preferably from 10 to 25% by weight, of the pulverized particles that pass the 0.125 mm sieve, based on the total weight of the pulverized material. The fine particles fill the spaces among the larger particles, so that the amount of air taken into tablets during molding can be reduced. However, when the amount of the fine particles exceeds 40% by weight, the bulk density may become low, which may increase the air bubbles taken and the molding of tablets may become difficult. Accordingly, in relation to the compression pressure and tablet density distribution into consideration, it is particularly preferably to control the amount of the particles having a particle size of 0.125 mm or less to 25% by weight or less based on the total weight of the pulverized material.

Density ratio of the aforementioned tablet-molded tablet is set to 94% or more and less than 98%. Particularly preferred is 96% or more and les than 98%. The reason for setting density ratio of the aforementioned tablet-molded tablet to less than 98% is as follows. That is, (1) even when the sheet density is set to 99 to 100%, very large pressurization is required for setting the tablet density to 98% or more, which is impossible or undesirable in view of the apparatus, (2) volatile components are remained in the material discharged from the kneader, and it absorbs water during storage due to its increased surface area caused by pulverization, so that the volatile components are present in the resin composition at the time of tablet making. When the resin composition under such a condition is made into a tablet having a high density of 98% or more, degassing and dehumidification can hardly be effected later on, and the volatile components can hardly be separated from the high density layer during resin fluidization at the time of molding and are apt to remain as voids as a result.

In this regard, the aforementioned tablet density ratio is measured and calculated in the following manner. That is, since the tablet is in a columnar shape, bulk specific gravity of the tablet is calculated from the diameter, height and weight of the tablet, and the tablet density ratio is calculated by its ratio with true specific gravity value of the molding material compact (hardened product of the resin composition). In more illustratively describing, the tablet density ratio is calculated from the bulk specific gravity of the tablet calculated in the above manner and the true specific gravity of the molding material compact calculated by the aforementioned method, based on the following formula, tablet density ratio (%) = [(bulk specific gravity of tablet)/(true specific gravity of molding material compact)] x 100.

The aforementioned pressure at the time of carrying out tablet-making molding into a tablet shape by compression is not particularly limited, but it is desirable to set it within the range of, e.g., from 245 to 784 MPa.

Thus, according to the present invention, it becomes possible to effectively inhibit formation of internal voids of a semiconductor device molded using the tablet, when all of the respective values of sheet density ratio and tablet density ratio satisfy the aforementioned ranges. Accordingly, when any one of the aforementioned values oversteps its setting range, the effects of the present invention may not be obtained. For example, even when density ratio of the finally obtained tablet is 97%, it is difficult to prevent formation of internal voids of the semiconductor device when the sheet density ratio before pulverization is less than 98%.

The size, etc. of the semiconductor-molding tablet of the present invention are not particularly limited as long as it is roughly a columnar shape, but it is preferably within the range of from 7 to 30 mm in diameter and from 10 to 45 mm in height.

Molding of a semiconductor elemental device using the semiconductor-molding tablet obtained in this manner is not limited, and it can be carried out by a known molding method such as transfer molding or the like.

Next, Invention Examples are described together with Comparative Examples.

Each of the components shown below was prepared.
Biphenyl type epoxy resin:
Epoxy equivalent 173, melting point 100°C
Phenol novolak resin:
Hydroxyl group equivalent 107, melting point 60°C
Hardening accelerator:
Triphenylphosphine
Carnauba wax
Inorganic filler:
Fused spherical silica powder (average particle size 20 µm)
Carbon black
Silane coupling agent:
γ-glycidoxypropyl trimethoxysilane

### Invention Examples 1 to 6 and Comparative Examples 1 to 6

Respective components shown in the following Table 1 were put into a mixer at the ratio shown in the same table and dry-blended, and then the aforementioned mixture was fed into a twin screw kneader and melt-kneaded at a resin temperature of 110°C. Next, the kneaded material discharged from this kneader was molded into a sheet shape by rolling it using a calender roller of 150 mm in diameter. In this case, gap, pushing pressure and the like of the roller were adjusted such that a sheet having a thickness shown in the following Table 2 was obtained. Next, the aforementioned melt-kneaded material molded into a sheet shape was air-cooled, pulverized using a hammer mill and then molded into a tablet shape. This tablet-making molding was carried out using a rotary tablet making machine (mfd. by Kikusui Seisakusho, 33 continuing type) in which the molding of tablets is continuously carried out while rotating a turntable on which a pair of mortar and pestle is arranged in two or more numbers. Thereafter, a semiconductor-molding tablet was prepared by compressing to a desired tablet density ratio.

**Table 1**

| Mixing components | Mixing parts (parts by weight) |
|---|---|
| Biphenyl type epoxy resin | 6 |
| Phenol novolak resin | 5 |
| Hardening accelerator | 0.5 |
| Carnauba wax | 0.5 |
| inorganic filler | 87 |
| Carbon black | 0.5 |
| Silane coupling agent | 0.5 |

Regarding each of the respective semiconductor-molding tablets obtained in this manner, the tablet density ratio was measured and calculated in accordance with the method described in the foregoing. Also, the aforementioned sheet density ratio at the time of roll-molding into each sheet shape was measured and calculated in accordance with the method described in the foregoing. In this connection, the aforementioned sheet thickness was measured using a pair of calipers after air-cooling the material molded into a sheet shape. These results are shown in the following Table 2 and Table 3.

Using each of the respective semiconductor-molding tablets obtained in this manner, a semiconductor device (20 samples) was prepared under the following conditions. Thereafter, inside of the thus obtained semiconductor device was observed using an X-ray apparatus to count the number of internal voids having a size of 100 µm or more, and average value of the number of internal voids in 20 samples of the semiconductor device was calculated. The results are shown in the following Table 2 and Table 3.
Semiconductor device size: 144 pin quad flat package (144 pin QFP) 20 mm x 20 mm
Chip size: 7.5 mm x 7.5 mm
Transfer molding condition: thermosetting at 175°C for 90 seconds
Molding pressure: 6.865 MPa
Molding machine: Multi-plunger System manufactured by TOWA
Fifty molded tablets (14 mmø; intended weight: 6 g) were prepared and each of the tablet was weighed. In accordance with the criterion below, the weight distribution was evaluated and the results are shown in Tables 2 and 3.
A: (Maximum value - minimum value)/average value < 0.3%
B: 0.3% ≤ (Maximum value - minimum value)/average value < 0.5%
C: 0.5% ≤ (Maximum value - minimum value)/average value < 2.0%
D: 2.0% ≤ (Maximum value - minimum value)/average value

The compression pressure required for molding the tablets were measured for each of the tablets of Invention Examples and Comparative Examples. The results are shown in Tables 2 and 3 as relative values with taking the value of Comparative Example 1 as 1.

**Table 2**

| | Invention Examples | | | | | |
|---|---|---|---|---|---|---|
| | 1 | 2 | 3 | 4 | 5 | 6 |
| Sheet density (%) | 98 | 98 | 99 | 100 | 98 | 98 |
| Sheet thickness (mm) | 1.0 | 1.0 | 0.7 | 0.5 | 1 | 1 |
| Tablet density (%) | 94 | 96 | 96 | 97 | 94 | 94 |
| Particle size of pulverized | 50 | 50 | 50 | 50 | 30 | 10 |
| material: >1 mm (% by weight) | | | | | | |
| Particle size of pulverized | 10 | 10 | 10 | 10 | 25 | 40 |
| material: ≤ 0.125 mm (% by weight) | | | | | | |
| The number of internal voids (numbers/20 packages) | 0.5 | 0.2 | 0.1 | 0 | 0.4 | 0.7 |
| Weight distribution | B | B | A | B | A | B |
| Compression pressure index (relative to Comparative Example 1) | 0.83 | 1.67 | 1.50 | 1.80 | 0.67 | 0.92 |

**Table 3**

| | Comparative Examples | | | | | |
|---|---|---|---|---|---|---|
| | 1 | 2 | 3 | 4 | 5 | 6 |
| Sheet density (%) | 96 | 98 | 100 | 96 | 96 | 96 |
| Sheet thickness (mm) | 2.3 | 1.0 | 0.5 | 2.3 | 2.3 | 2.3 |
| Tablet density (%) | 94 | 93 | 98 | 94 | 94 | 94 |
| Particle size of pulverized | 50 | 50 | 50 | 55 | 50 | 5 |
| material: >1 mm (% by weight) | | | | | | |
| Particle size of pulverized | 10 | 10 | 10 | 10 | 5 | 50 |
| material: ≤ 0.125 mm (% by weight) | | | | | | |
| The number of internal voids (numbers/20 packages) | 1.3 | 2.0 | 1.3 | 2.2 | 2.0 | 2.0 |
| Weight distribution | B | B | C | C | C | D |
| Compression pressure index (relative to Comparative Example 1) | 1 | 0.75 | 3.17 | 1.17 | 1.17 | 1.33 |

As is evident from the aforementioned results, internal voids were not formed or very little, if formed, in the semiconductor devices produced using a tablet having a tablet density ratio of 94% or more and less than 98% prepared by carrying out tablet-making molding of a pulverized material comprising a rolled sheet having a sheet density ratio of 98% or more.

On the other hand, in the semiconductor devices prepared using tablets corresponding to either a sheet density ratio of less than 98% or a tablet density ratio of less than 94% or 98% or more, internal voids were formed in large amounts in comparison with Invention Examples.

As has been described in the foregoing, according to the present invention, a semiconductor-molding tablet is produced by roll-molding a kneaded material of an epoxy resin composition into a sheet shape having a sheet density ratio of 98% or more, pulverizing the aforementioned sheet shaped compact, and then making this pulverized material into a tablet shape having a tablet density ratio of 94% or more and less than 98%. Thus, by setting the sheet density ratio to the aforementioned range, it becomes possible to obtain a high density tablet which is difficult to realize by the conventional tablet making techniques and tablet making apparatus when the pulverized material is used. Accordingly, a semiconductor device prepared by resin-molding using a tablet obtained by the production method of the present invention shows reduced generation of voids and has high reliability.

In addition, by setting thickness of the aforementioned roll-molded sheet to 1.0 mm or less, it becomes easy to increase the sheet density ratio to a high density of 98% or more.

While the invention has been described in detail and with reference to specific embodiments thereof, it will be apparent to one skilled in the art that various changes and modifications can be made therein without departing from the scope of the claims.

## Claims

1. A method for producing a semiconductor-molding tablet, which comprises
a step of melt-kneading an epoxy resin composition comprising components: (A) an epoxy resin, (B) a phenol resin and (C) an inorganic filler, as essential components,
a step of roll-molding the resulting kneaded composition into a sheet shape having a thickness of 1,0 mm or less and a sheet density ratio of 98% or more,
a step of pulverizing the resulting sheet-shaped compact, and
a step of forming the pulverized material into a tablet shape having a tablet density ratio of 94% or more and less than 98%.

2. The method for producing a semiconductor-molding tablet according to claim 1, wherein the pulverized material has 50% by weight or less of particles having a particle size of more than 1.0 mm and 10 to 40% by weight of particles having a particle size of 0.125 nun or less, based on the total weight of the pulverized material.

## Patentansprüche

1. Verfahren zum Herstellen einer Halbleiterformtafel, die folgendes umfasst:
Einen Schritt eines Schmelzknetens einer Epoxidharzzusammensetzung mit folgenden Komponenten:
(A) Ein Epoxidharz, (B) ein Phenolharz und (C) einen anorganischen Füller als wichtige Komponenten,
einen Schritt eines Rollformens, der resultierenden gekneteten Zusammensetzung in eine Folienform mit einer Dicke von 1,0 mm oder weniger und einem Foliendichteverhältnis von 98 % oder mehr,
einen Schritt des Pulverisierens des resultierenden folienförmigen Presskörpers, und
einen Schritt des Formens des pulverisierten Materials in eine Folienform mit einem Foliendichteverhältnis von 94 % oder mehr und weniger als 98 %.

2. Das Verfahren zum Herstellen einer Halbleiterschmelztafel nach Anspruch 1, wobei das pulverisierte Material 50 % an Gewicht oder weniger der Partikel hat, mit einer Partikelgröße von mehr als 1 mm und 10 bis 40 Gewichtsprozent an Partikeln, die eine Partikelgröße von 0,125 mm oder weniger aufweisen, basierend auf einem Gesamtgewicht an pulverisiertem Material.

## Revendications

1. Procédé de production d'une pastille de moulage de semi-conducteur, qui comprend
une étape de malaxage en fusion d'une composition de résine époxy comprenant les composants : (A) une résine époxy, (B) une résine de phénol et (C) une charge inorganique, en tant que composants essentiels,
une étape de moulage au rouleau de la composition malaxée résultante en une forme de feuille ayant une épaisseur de 1,0 mm ou moins et un rapport de densité de feuille de 98 % ou plus,
une étape de pulvérisation du comprimé en forme de feuille résultant, et
une étape de formation du matériau pulvérisé en une forme de pastille ayant un rapport de densité de pastille de 94 % ou plus et inférieur à 98 %.

2. Procédé de production d'une pastille de moulage de semi-conducteur selon la revendication 1, dans lequel le matériau pulvérisé comporte 50% en poids ou moins de particules ayant une taille de particule de plus de 1,0 mm et 10 à 40 % en poids de particules ayant une taille de particule de 0,125 nm ou moins, sur la base du poids total du matériau pulvérisé.
